# EUROPEAN PATENT APPLICATION

(11) **EP 1 758 182 A1**
(43) Date of publication of application: **28.02.2007**
(21) Application number: 06118743.1
(22) Date of filing: 10.08.2006
(51) Int. Cl.: H01L 51/52, H05B 33/04

(54) **Electroluminescence panel and method for manufacturing electroluminescence panel**

(30) Priority: 24.08.2005 JP 2005243204
(71) Applicant: KABUSHIKI KAISHA TOYOTA JIDOSHOKKI, Kariya-shi, Aichi 448-8671 (JP)
(72) Inventor: Yoshida, Hiroaki, Kariya-shi, Aichi 448-8671 (JP); Muta, Mitsuharu, Kariya-shi, Aichi 448-8671 (JP); Naito, Hisashi, Kariya-shi, Aichi 448-8671 (JP)
(74) Representative: TBK-Patent

(57) **Abstract**

A method for manufacturing an electroluminescence panel (11) includes: forming a light emitting portion (16) in each of a plurality of portions of a glass substrate (25); forming a protective layer (17) of an inorganic material that can be cut apart by a scribe and break method to cover the light emitting portions (16); providing a scribe line (22) on a surface (25b) of the glass substrate (25) opposed to a surface (25a) in which the protective layer (17) has been formed and at a position corresponding to the protective layer (17); and cutting the glass substrate (25) and the protective layer (17) along the scribe line (22) in such a manner as to divide the glass substrate (25) into a plurality of sections (12) each including the light emitting portion (16). Thus, a scribe clearance for breaking the single glass substrate (25) is decreased (Fig. 4).

## Description

### BACKGROUND OF THE INVENTION

The present invention relates to an electroluminescence panel and a method for manufacturing the electroluminescence panel.

Typically, a display panel such as a liquid crystal panel is manufactured from a layered mother substrate (a mother panel), which is formed of bonding two large-sized glass substrates together. The mother panel is cut apart in accordance with the size of each display panel using a scribe and break method, thus forming multiple display panels from the substrate (see, for example, Japanese Laid-Open Patent Publication No. 2004-348111). Specifically, according to the scribe and break method, scribe lines (scribe grooves) are defined in one of the glass substrates of the mother panel through machining. The mother panel is then reversed and the other glass substrate, which does not have the scribe lines, is pressed at the positions corresponding to the scribe lines. The mother panel is thus broken (cut apart) along the scribe lines.

As a backlight of a liquid crystal display, an illumination device including an electroluminescence element (an electroluminescence panel) has been proposed. The term "electroluminescence" is hereinafter abbreviated as "EL". An EL panel includes an EL element formed on a glass substrate. The EL element includes an anode, a cathode, and a light emitting layer arranged between the anode and the cathode. If the light emitting layer is formed of an organic substance as in an organic EL panel, the light emitting layer may be easily influenced by moisture and oxygen in an adverse manner. To avoid this, the organic EL panel is formed by bonding a glass substrate including an organic EL element with a sealing glass substrate through a seal material.

Alternatively, for the same purpose, an organic EL panel may include a protective layer that covers an anode, a light emitting layer, and a cathode, which are layered on a glass substrate.

Nonetheless, formation of the organic EL panel with the protective layer has not been put to practical use. It is desired that a novel method to form organic EL panels each including a protective layer from a mother panel.

### SUMMARY OF THE INVENTION

Accordingly, it is an objective of the present invention to provide a novel EL panel and a novel method for manufacturing the EL panel, in which a plurality of light emitting portions are formed, into multiple EL panels using a scribe and break method.

According to one aspect of the invention, an electroluminescence panel comprising a glass substrate and a light emitting portion formed on the glass substrate is provided. The light emitting portion includes a first electrode, a second electrode, and an electroluminescence light emitting layer arranged between the first and second electrodes. A protective layer is formed of an inorganic material to cover the light emitting portion. The protective layer can be cut apart by a scribe and break method. The glass substrate and the protective layer have been cut apart at positions corresponding to the protective layer.

According to another aspect of the invention, a method for manufacturing an electroluminescence panel is provided. The method includes the steps of: forming a light emitting portion having an electroluminescence light emitting layer arranged between a first electrode and a second electrode in each of a plurality of portions of a glass substrate; forming a protective layer of an inorganic material that can be cut apart by a scribe and break method to cover the light emitting portions. The method further includes providing a scribe line on a surface of the glass substrate opposed to a surface in which the protective layer has been formed and at a position corresponding to the protective layer; and cutting the glass substrate and the protective layer along the scribe line in such a manner as to divide the glass substrate into a plurality of sections each including the light emitting portion.

Other aspects and advantages of the invention will become apparent from the following description, taken in conjunction with the accompanying drawings, illustrating by way of example the principles of the invention.

### BRIEF DESCRIPTION OF THE DRAWINGS

The invention, together with objects and advantages thereof, may best be understood by reference to the following description of the presently preferred embodiments together with the accompanying drawings in which:
Fig. 1 is a cross-sectional view schematically showing an organic EL panel according to an embodiment of the present invention;
Fig. 2 is a flowchart representing a procedure for manufacturing the organic EL panel;
Fig. 3 is a perspective view schematically showing a mother panel before cutting;
Fig. 4 is a cross-sectional view schematically showing a portion of the mother panel before cutting;
Fig. 5 is a cross-sectional view schematically showing a portion of a mother panel according to another embodiment of the present invention before cutting; and
Fig. 6 is a cross-sectional view schematically showing a portion of a comparative mother panel before cutting.

### DETAILED DESCRIPTION OF THE PREFERRED EMBODIMENTS

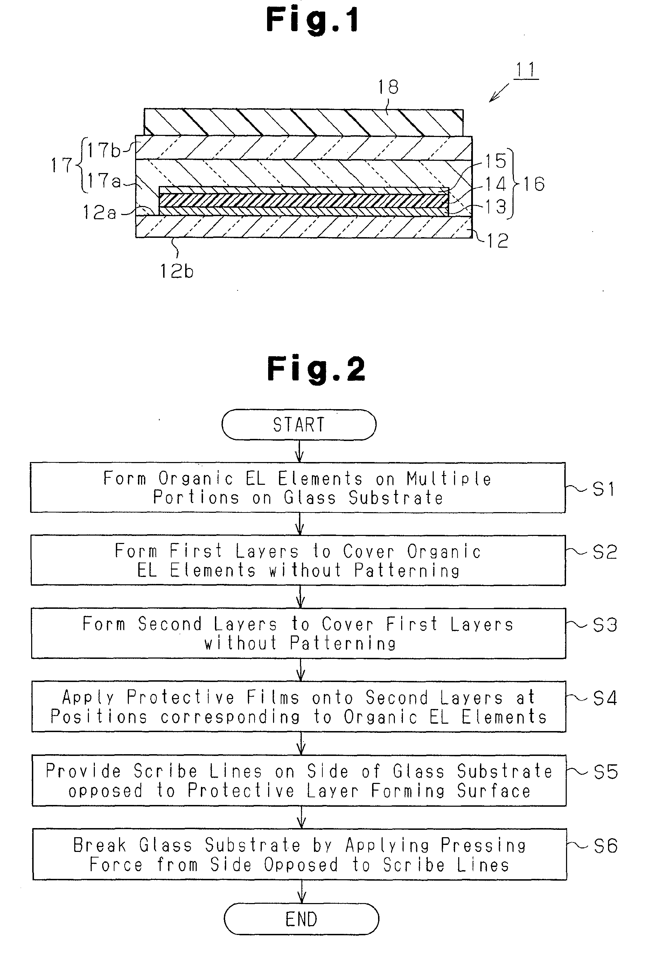

An embodiment of the present invention, or an organic EL panel as an EL panel, will hereafter be described with reference to Figs. 1 to 4.

As shown in Fig. 1, an organic EL panel 11 includes a glass substrate 12 and an organic EL element 16, or an EL element, which is provided on the glass substrate 12. The glass substrate 12 has a first surface 12a, on which the organic EL element 16 is formed, and a second surface 12b, which is opposed to the first surface 12a. The organic EL element 16 includes a first electrode 13, an organic EL layer 14, or an electroluminescence light emitting layer, and a second electrode 15 that are sequentially formed on the glass substrate 12 in this order. The organic EL element functions as a light emitting portion. The EL element 16 is covered by a protective layer 17 to prevent the organic EL layer 14 from being adversely influenced by moisture (vapor) and oxygen. A protective film 18 is bonded with the surface of the protective layer 17 opposed to the organic EL element 16 in such a manner as to substantially cover the entire surface.

In Fig. 1, the organic EL panel 11, the glass substrate 12, the first electrode 13, the organic EL layer 14, the second electrode 15, the protective layer 17, and the protective film 18 are schematically illustrated. For the illustrative purposes, these components are shown in partially exaggerated sizes. Therefore, the proportion of dimensions of each component, including length and thickness, is different from the actual proportion.

In the illustrated embodiment, the first electrode 13 forms an anode and the second electrode 15 forms a cathode. The first electrode 13 is formed of transparent material. The "transparent" material herein is defined as a material that is transparent to, at least, visible light. The first electrode 13 is formed of ITO (indium-tin oxide), which is used for forming a transparent electrode of a known organic EL element. The second electrode 15 is formed of metal (for example, aluminum) and reflects light. The organic EL element 16 is configured as a bottom emission type in which the light from the organic EL layer 14 emerges (exits) from the side of the organic EL element 16 facing the glass substrate 12.

The organic EL layer 14 is formed of a known organic EL material and includes, for example, a hole transport layer, a light emitting layer, and an electron transport layer that are sequentially provided in this order from the side corresponding to the first electrode 13. The organic EL layer 14 emits white light and capable of full-color displaying using a color filter when the organic EL panel 11 is used as a backlight of a liquid crystal display. As is known publicly, emission of the white light may be accomplished by providing a red light emitting layer, a green light emitting layer, and a blue light emitting layer, which emit white light as a whole. These layers may be formed through planar coloring small segments in different colors or layer deposition. Alternatively, the white light emission may be achieved by dispersing red pigments, green pigments, and blue pigments in host molecules or high molecules.

The protective layer 17 has a two-layered structure including a first layer 17a and a second layer 17b. The first layer 17a opposes the organic EL element 16 and covers the portions of the organic EL element 16 other than the portion facing the glass substrate 12. The second layer 17b covers the surface of the first layer 17a opposed to the side opposing the organic EL element 16.

The protective layer 17 is formed of an inorganic material that can be cut apart by a scribe and break method, which is, for example, ceramic. In the illustrated embodiment, the first layer 17a is formed of a silicon nitride film and the second layer 17b is formed of a silicon oxide film. The protective layer 17 has a broken (cut) surface formed through the scribe and break method.

The protective film 18 is formed of a plastic film, which is, for example, a polyethylene terephthalate film (a PET film) in the illustrated embodiment.

Next, a method for manufacturing the organic EL panel 11 will be explained.

First, in step S1, or an organic EL element forming step, organic EL elements 16 are formed in a plurality of portions of the mother substrate 25, which is sufficiently large for obtaining multiple organic EL panels 11, using a known method. That is, the mother substrate 25 is sufficiently large for obtaining multiple glass substrates 12. Specifically, for example, a transparent mother substrate 25 having an ITO film is prepared. The ITO film is subjected to etching to form first electrodes 13. The mother substrate 25 and the first electrodes 13 are then cleansed. Subsequently, organic EL layers 14 are formed on the first electrodes 13 through, for example, vapor deposition to cover the first electrodes 13. That is, each of the organic EL layers 14 is formed by sequentially vapor-depositing the multiple layers forming the organic EL layer 14. Afterwards, second electrodes 15 are formed on the organic EL layers 14 through deposition of aluminum.

Then, in step S2, first layers 17a are formed to cover the organic EL elements 16 without patterning. The first layers 17a, which are formed of the silicon nitride films, are provided by, for example, a plasma CVD method.

Subsequently, in step S3, second layers 17b are formed to cover the first layers 17a without patterning. The second layers 17b, which are formed of the silicon oxide films, are provided by applying polysilazane solution onto the surfaces of the first layers 17a. The solution is then subjected to an oxidization process, thus providing the silicon oxide films.

Steps S2 and S3 define a protective layer forming step. In this step, the protective layers 17, which are formed of the inorganic material that can be cut apart by the scribe and break method, are formed to cover the organic EL elements 16 without patterning. The protective layers 17 are thus provided on an entire portion of the corresponding surface of the mother substrate 25 without patterning. The protective layers 17 are thus formed easily compared to a case in which the protective layers 17 are provided through patterning. That is, the protective layer 17 is formed to cover a plurality of the light emitting portions. In other words, the light emitting portions 16 are separated from one another, and the protective layer 17 is formed to cover gaps between the light emitting portions. Further, the thicknesses of the protective layers 17, which are provided on the organic EL elements 16 formed on the mother substrate 25, become substantially uniform.

Then, in step S4, or a protective film applying step, protective films 18 are applied onto portions of the second layers 17b corresponding to the organic EL elements 16.

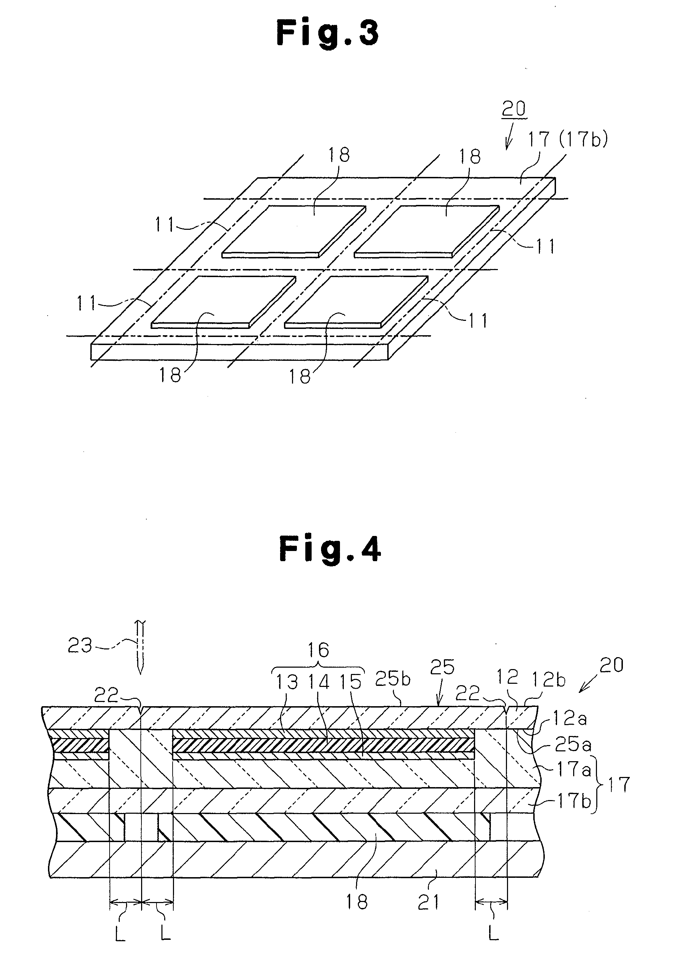

In this manner, as illustrated in Fig. 3, a mother panel 20 is prepared. The mother panel 20 includes the organic EL panels 11, which are connected together at this stage. The mother panel 20 is to be cut apart at the cutting positions indicated by the double-dotted broken lines of Fig. 3.

Subsequently, in step S5, or a scribing step, scribe lines 22 are formed on a second surface 25b (12b) of the mother substrate 25 of the mother panel 20 opposed to a first surface 25a (12a) corresponding to the protective layers 17, which have been formed on the mother substrate 25. Specifically, as illustrated in Fig. 4, the mother panel 20 is held by suction of a scriber surface plate 21 at the side corresponding to the protective films 18. Each of the scribe lines 22 is provided at a position spaced from the end of the corresponding organic EL element 16 at a predetermined distance L, using a cutter 23. That is, the scribe line 22 is defined in correspondence with a portion of the protective layer 17 that covers the gaps between the light emitting portions 16. The cutter 23 is, for example, a diamond cutter. In this manner, the scribe lines 22 necessary for obtaining the organic EL panels 11 from the mother panel 20 are sequentially formed.

Next, in step S6, or a breaking step, the mother panel 20 is cut apart to separate the organic EL panels 11 from one another. Specifically, the mother panel 20 is held by suction at the side corresponding to the mother substrate 25. The mother substrate 25 is then pressed from the protective layers 17 sequentially at the positions corresponding to the scribe lines 22. The mother substrate 25 is thus cut apart together with the protective layers 17. "Pressing" of the mother substrate 25 refers to application of force having a component acting in a vertical direction to the surface of the mother substrate 25, regardless of whether the force is applied to the mother substrate 25 slowly or quickly like an impact caused by striking. In this manner, the organic EL panels 11 are completed.

Operation of the organic EL panel 11 will hereafter be described. The organic EL panel 11 may be used as, for example, a backlight of a liquid crystal display.

When a non-illustrated power supply supplies a DC drive voltage between the first electrode 13 and the second electrode 15, an electric current flows from the first electrode 13 to the organic EL layer 14 and reaches the second electrode 15. In this state, the organic EL layer 14 emits light and the light transmits through the first electrode 13, which is a transparent electrode. The light then exits the first electrode 13 from the side corresponding to the glass substrate 12.

As has been described, the organic EL element 16 is covered by the protective layer 17 to prevent the organic EL layer 14 from being adversely influenced by moisture and oxygen. The protective layer 17 includes the first layer 17a, or the silicon nitride film formed by the CVD method, and the second layer 17b, or the silicon oxide film formed through application and oxidization of polysilazane. When forming a layer by the CVD method, a longer time is necessary to increase the thickness of the layer sufficiently for satisfying a prescribed level of protection performance than a case in which the layer is formed through application of material. If the layer is excessively thin, pin holes may form. However, in the illustrated embodiment, the protective layer 17 has the second layer 17b, which is formed through application and oxidization of polysilazane. This shortens the time needed for forming the protective layer 17 with equivalent protection performance.

The illustrated embodiment has the following advantages.

(1) The organic EL panel 11 has the glass substrate 12, the organic EL element 16 formed on the glass substrate 12, and the protective layer 17. The organic EL element 16 includes the first electrode 13, the second electrode 15, and the organic EL layer 14 arranged between the first and second electrodes 13, 15. The protective layer 17 is formed of the inorganic material that can be cut apart by the scribe and break method. The organic EL element 16 is covered by the protective layer 17. The organic EL panel 11 is cut apart from other organic EL panels 11 at the positions corresponding to the protective layer 17. Thus, when manufacturing the organic EL panel 11, the protective layer 17 does not necessarily have to be formed through patterning accurately in accordance with the shape of the organic EL element 16. This reduces the scribe clearance for forming the multiple organic EL panels 11 from the single mother substrate 25, which is a single glass substrate, by the scribe and break method. Further, the organic EL panel 11 becomes smaller in size.

Although the protective layer 17 of the illustrated embodiment is formed of the material that can be cut apart by the scribe and break method, the scribe lines 22 for breaking are not provided directly on the protective layer 17. The scribe lines 22 are defined on portions of the mother substrate 25 (glass substrate) corresponding to the protective layer 17. Pressing force is applied to the mother substrate 25 (glass substrate) from the side corresponding to the protective layer 17. The protective layer 17 is thus broken (cut apart) together with the mother substrate 25 (glass substrate).

As a comparative example, to form organic EL panels each including a protective layer from a mother panel, the protective layers are formed on a mother substrate (glass substrate) of the mother panel through patterning in shapes corresponding to the organic EL panels. The mother substrate may be then cut apart by the scribe and break method at the positions at which the protective layers are not provided. However, a portion corresponding to each protective layer formed through patterning includes an outer peripheral portion with decreased thickness. In other words, a portion with decreased thickness is formed around a protective portion of the protective layer with sufficient thickness. The portion corresponding to the protective layer formed through patterning thus becomes larger in size. This increases a scribe clearance, or the distance between the end of each EL element and the corresponding scribe line, decreasing the number of the EL panels that can be obtained from the single mother substrate, which is a single glass substrate.

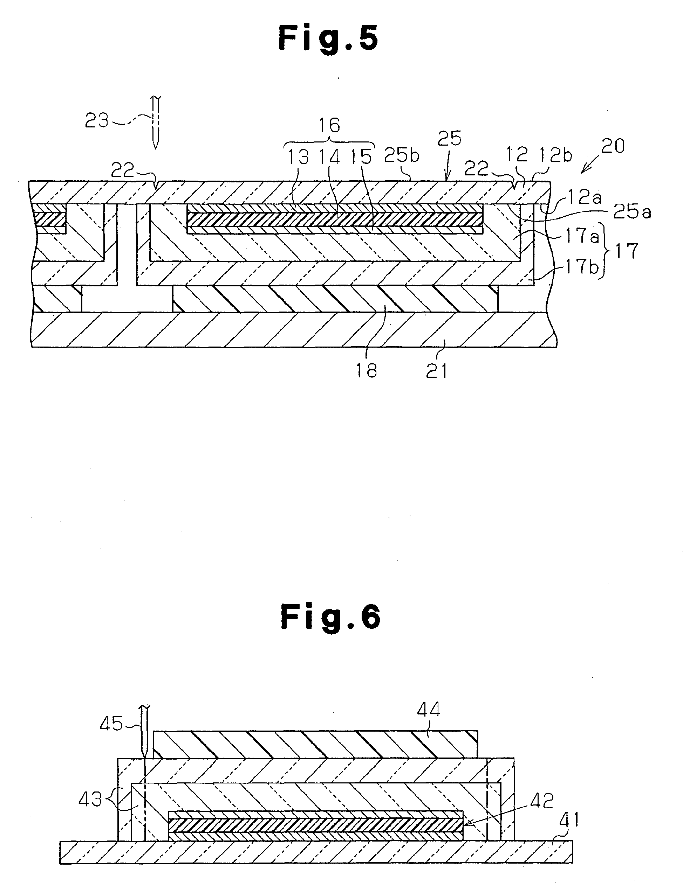

To decrease the scribe clearance, as illustrated in Fig. 6, scribing may be performed over a protective layer 43, which covers an organic EL element 42 formed on a glass substrate 41, using a cutter 45 as indicated by the double-dotted line. A protective film 44 is bonded with a surface of the protective layer 43. However, when subjected to such scribing, the protective layer 43 scatters apart and hampers formation of a vertical crack in the glass substrate 41. Also, the cut surface of the glass substrate 41 becomes rough, greatly varying the outlines of the thus obtained products. Further, the glass substrate 41 is easily influenced by reactive force acting laterally, causing cracks.

Contrary to this comparative example of Fig. 6, in the present embodiment, the scribe clearance for forming the multiple organic EL panels 11 from the single mother substrate 25 by the scribe and break method is reduced by defining scribe lines 22 on portions of the glass substrate 12 (mother substrate 25) corresponding to the protective layer 17 and applying pressing force to the glass substrate 12 (mother substrate 25) from the side corresponding to the protective layer 17.

(2) The protective layer 17 has the first layer 17a formed of the silicon nitride film and the second layer 17b formed of the silicon oxide film. The protective layer 17 that can be cut apart by the scribe and break method is reliably formed with necessary protective performance.

(3) To manufacture the organic EL panels 11, the multiple light emitting portions (organic EL elements 16) are first formed on the mother substrate 25. Subsequently, the protective layer forming step is performed. In other words, the protective layers 17 formed of the inorganic material that can be cut apart by the scribe and break method are provided to cover the organic EL elements 16 without patterning. The organic EL panels 11 are thus easily manufactured compared to the case in which the protective layers 17 are formed through patterning in correspondence with the organic EL elements 16.

Further, since the protective layers 17 are provided without patterning, the protective layers 17 of the organic EL elements 16 formed on the mother substrate 25 (glass substrate 12) have substantially uniform thicknesses. Thus, unlike the case in which the protective layers 17 are provided through patterning, the organic EL panels 11 are obtained from the mother panel 20 by providing a single scribe line between an adjacent pair of the organic EL panels 11. This shortens the distance between each adjacent pair of the organic EL elements 16. Accordingly, an increased number of organic EL panels 11 are easily formed from the mother substrate 25 (glass substrate) without increasing the surface area of the mother substrate 25.

(4) To manufacture the organic EL panels 11, the scribing step is performed after the protective layer forming step. In the scribing step, the scribe lines 22 are formed on the second surface 25b of the mother substrate 25 (glass substrate) opposed to the first surface 25a on which the protective layers 17 are formed and at the positions corresponding to the protective layers 17. Subsequently, the breaking step is carried out. In other words, pressing force is applied to the mother substrate 25 (glass substrate) on which the scribe lines 22 have been formed. The mother substrate 25 is thus cut apart together with the protective layers 17 along the scribe lines 22. This reduces the scribe clearance. Further, an increased number of organic EL panels 11 are obtained from the mother substrate 25 (glass substrate) without increasing the surface area of the mother substrate 25 or decreasing the surface area of the organic EL panels 11.

(5) The protective layer 17 is formed of the first layer 17a, or the silicon nitride film formed by the CVD method, and the second layer 17b, or the silicon oxide film formed through oxidation of polysilazane. This improves productivity for forming the protective layers 17, compared to a case in which each protective layer 17 with necessary protection performance must be formed solely by the first layer 17a.

The illustrated embodiment is not limited to the above-described forms but may be modified in the following forms.

The protective layer 17 is not limited to the double-layered structure having the first layer 17a, or the silicon nitride film, and the second layer 17b, or the silicon oxide film. The protective layer 17 may be configured in any other suitable form as long as the protective layer 17 is formed of a material that can be cut apart by the scribe and break method and has the necessary protection performance. For example, the protective layer 17 may include at least one of a silicon nitride film, a silicon oxynitride film, and a silicon oxide film. If the protective layer 17 is formed of silicon type ceramic, the protective layer 17 exhibits an improved affinity with the glass substrate 12 (mother substrate 25) and can be easily cut apart by the scribe and break method.

The silicon oxide film does not necessarily have to be formed through application and oxidization of polysilazane but may be formed by the CVD method. If the protective layer 17 is formed as a single-layered structure of the silicon oxide film, the organic EL layer 14 may be adversely influenced by application of polysilazane solution. Thus, in this case, it is preferable to provide the silicon oxide film by any suitable method different from the application and oxidization of polysilazane. If the protective layer 17 includes two or more layers and the silicon oxide film is formed after a first layer, the silicon oxide film can be provided through the application and oxidization of polysilazane.

As illustrated in Fig. 5, the protective layers 17 may be formed through patterning in shapes corresponding to the organic EL elements 16, which have been provided on the mother substrate 25 (glass substrate). In this case, the scribe lines 22 are formed on the second surface of the mother substrate 25 opposed to the protective layers 17 at positions that are spaced from the ends of the organic EL elements 16 at a predetermined distance and at which the first layers 17a overlap the second layers 17b. The mother panel 20 is then held by suction by the scriber surface plate 21. The mother panel 20 is thus cut apart by applying the pressing force to the mother panel 20 from the side corresponding to the protective layers 17.

If the organic EL panels 11 are arranged on the single mother panel 20 by multiple lines and multiple rows, breaking does not necessarily have to be carried out sequentially from an end of the mother panel 20 after all necessary scribe lines 22 have been provided. That is, for example, scribe lines 22 may be formed solely for the lines or the rows. The mother panel 20 is then subjected to breaking in such a manner that the lines or the rows of organic EL panels 11 are obtained. In each of the lines or the rows, the organic EL panels 11 are arranged sequentially. Subsequently, scribe lines 22 are provided in correspondence with each of the organic EL panels 11 of the respective lines or rows. Breaking is then performed on the lines or the rows of the organic EL panels 11.

The protective film 18 may be omitted.

The material of the first electrode 13 is not limited to the ITO but may be IZO (indium-zinc oxide), ZnO (zinc oxide), or SnO₂ (tin oxide).

The second electrode 15 does not necessarily have to be formed of aluminum but may be formed of a known cathode material including metals such as gold, silver, copper, and chrome and alloys of these metals.

The second electrode 15 does not necessarily have to reflect light.

The organic EL panel 11 does not necessarily have to radiate light from the side corresponding to the glass substrate 12. The organic EL panel 11 may be formed as a top emission type in which the light exits the organic EL panel 11 from the side opposed to the glass substrate 12. In this case, the organic EL element 16 includes a transparent electrode, or, for example, the first electrode 13, which is arranged at the side opposed to the glass substrate 12. The organic EL layer 14 is arranged between the glass substrate 12 and the first electrode 13. The second electrode 15 is provided at the side corresponding to the glass substrate 12.

The color of the light emitted by the organic EL layer 14 is not limited to white but may be a plain color such as red, blue, green, or yellow or a combination of any of these colors.

The EL panel according to the present invention is not limited to the organic EL panel 11 but may be an inorganic EL element having an inorganic EL layer as an EL light emitting layer instead of the organic EL layer 14.

The present invention is not limited to application to the EL panel that emits light from the entire area as a backlight or an illumination device. However, the invention may be applied to an EL display panel capable of emitting light from limited parts.

In the illustrated embodiment, to separate the organic EL panels 11 from one another, breaking (cutting) is performed in step S6 by applying the pressing force to the surface of the mother panel 20 opposed to the surface on which the scribe lines 22 have been formed. However, the breaking of the present invention is not limited to this. That is, the mother panel 20 may be broken only by forming the scribe lines 22.

A method for manufacturing an electroluminescence panel (11) includes: forming a light emitting portion (16) in each of a plurality of portions of a glass substrate (25); forming a protective layer (17) of an inorganic material that can be cut apart by a scribe and break method to cover the light emitting portions (16); providing a scribe line (22) on a surface (25b) of the glass substrate (25) opposed to a surface (25a) in which the protective layer (17) has been formed and at a position corresponding to the protective layer (17); and cutting the glass substrate (25) and the protective layer (17) along the scribe line (22) in such a manner as to divide the glass substrate (25) into a plurality of sections (12) each including the light emitting portion (16). Thus, a scribe clearance for breaking the single glass substrate (25) is decreased (Fig. 4).

## Claims

1. An electroluminescence panel comprising:
a glass substrate (12);
a light emitting portion (16) formed on the glass substrate (12), wherein the light emitting portion (16) includes a first electrode (13), a second electrode (15), and an electroluminescence light emitting layer (14) arranged between the first and second electrodes (13, 15); and
a protective layer (17) formed of an inorganic material to cover the light emitting portion (16),
the electroluminescence panel being **characterized in that**:
the protective layer (17) can be cut apart by a scribe and break method, and wherein the glass substrate (12) and the protective layer (17) have been cut apart at positions corresponding to the protective layer (17).

2. The electroluminescence panel according to claim 1, **characterized in that** the protective layer (17) includes at least one of a silicon nitride film, a silicon oxynitride film, and a silicon oxide film.

3. The electroluminescence panel according to claim 2, **characterized in that** the protective layer (17) includes a first layer (17a) and a second layer (17b) that are stacked together, the first layer (17a) being arranged at a side corresponding to the light emitting portion (16) and formed of a silicon nitride film, the second layer (17b) covering the first layer (17a) and being formed of a silicon oxide film.

4. The electroluminescence panel according to any one of claims 1 to 3, **characterized in that** the electroluminescence light emitting layer (14) is an organic electroluminescence light emitting layer (14).

5. A method for manufacturing an electroluminescence panel, comprising the steps of:
forming a light emitting portion (16) having an electroluminescence light emitting layer (14) arranged between a first electrode (13) and a second electrode (15) in each of a plurality of portions of a glass substrate (25) (S1);
forming a protective layer (17) of an inorganic material,
the method being **characterized in that** the protective layer (17) can be cut apart by a scribe and break method to cover at least one of the light emitting portions (16) (S2, S3);
providing a scribe line (22) on a surface (25b) of the glass substrate (25) opposed to a surface (25a) in which the protective layer (17) has been formed and at a position corresponding to the protective layer (17) (S5); and
cutting the glass substrate (25) and the protective layer (17) along the scribe line (22) in such a manner as to divide the glass substrate (25) into a plurality of sections (12) each including the light emitting portion (16) (S6).

6. The method according to claim 5, **characterized in that** the cutting step (S6) includes applying a pressing force to the glass substrate (25) from the surface (25a) opposed to the surface (25b) in which the scribe line (22) has been formed.

7. The method according to claim 5 or 6, **characterized in that** the protective layer forming step (S2, S3) includes formation of the protective layer (17) to cover a plurality of the light emitting portions (16).

8. The method according to any one of claims 5 to 7, **characterized in that** the light emitting portions (16) are separated from one another, the protective layer (17) being formed to cover gaps between the light emitting portions (16).

9. The method according to claim 8, **characterized in that** the scribe line (22) is defined in correspondence with a portion of the protective layer (17) that covers the gaps between the light emitting portions (16).

10. The method according to any one of claims 5 to 9, **characterized in that** the protective layer forming step includes:
forming a first layer (17a) by a CVD methods (S2); and
forming a second layer (17b) through application and oxidization of polysilazane (S3).

11. The method according to any one of claims 5 to 10, **characterized in that** the electroluminescence light emitting layer (14) is an organic electroluminescence light emitting layer (14).
